# EUROPEAN PATENT SPECIFICATION

(11) **EP 3 125 286 B1**
(45) Date of publication and mention of the grant of the patent: **08.05.2019**
(21) Application number: 15767745.1
(22) Date of filing: 26.03.2015
(51) Int. Cl.: H01L 23/13, C04B 37/02

(54) **CIRCUIT BOARD AND ELECTRONIC DEVICE PROVIDED WITH SAME**
LEITERPLATTE UND ELEKTRONISCHE VORRICHTUNG DAMIT
CARTE DE CIRCUIT IMPRIMÉ ET DISPOSITIF ÉLECTRIQUE LA COMPORTANT

(30) Priority: 26.03.2014 JP 2014063965
(43) Date of publication of application: 01.02.2017
(73) Proprietor: Kyocera Corporation, Kyoto-shi, Kyoto 612-8501 (JP)
(72) Inventor: KOMATSUBARA,Kenji, Kyoto-shi Kyoto 612-8501 (JP); ISHIKAWA,Kazuhiro, Kyoto-shi Kyoto 612-8501 (JP); ABE,Yuuichi, Kyoto-shi Kyoto 612-8501 (JP); NAKAMURA,Kiyotaka, Kyoto-shi Kyoto 612-8501 (JP)
(74) Representative: Viering, Jentschura & Partner mbB Patent- und Rechtsanwälte
(86) International application number: PCT/JP2015/059443
(87) International publication number: WO 2015/147193

(56) References cited:
- WO-A1-2011/034075
- WO-A1-2013/008651
- JP-A- 2004 314 161
- JP-A- 2005 252 087
- JP-A- 2012 092 006
- JP-A- 2013 030 616

## Description

### Technical Field

The present invention relates to a circuit board and an electronic device provided with the circuit board.

### Background Art

Electronic devices including semiconductor elements, such as insulated-gate bipolar transistor (IGBT) elements, metal oxide semiconductor field-effect transistor (MOSFET) elements, light-emitting diode (LED) elements, freewheeling diode (FWD) elements, giant transistor (GTR) elements, and heat-generating elements, such as sublimation thermal printer head elements, thermal inkjet printer head elements, and Peltier elements, mounted on circuit members of circuit boards have recently been used as electronic components.

As a circuit board used for such an electronic device, for example, PTL 1 discloses a circuit board including a ceramic substrate, a copper circuit plate bonded to at least one surface of the ceramic substrate through a brazing material layer containing Ag, Cu, and Ti, and a brazing material protrudent part formed of a portion of the blazing layer protruding outward from a side surface of the copper circuit plate, in which the total amount of a Ti phase and a TiN phase in the brazing material protrudent part is 3% by mass or more and is different from the total amount of a Ti phase and a TiN phase in a portion of the brazing material layer interposed between the ceramic substrate and the copper circuit plate, and the number of voids each having an area of 200 µm² or less in the brazing material protrudent part is one or less (including zero).

### Citation List

### Patent Literature

PTL 1: International Publication No. 2011/034075 JP2005 252087 A discloses a circuit board, comprising a circuit member located on one main surface of a ceramic substrate with a bonding layer in-between.

### Summary of Invention

### Technical Problem

An element mounted on the copper circuit plate generates heat in operation. Thus, the circuit board is exposed to a cool-heat cycle (also referred to as a "heat cycle") by the repetition of stop and operation. The portion of the blazing layer protruding outward from a side surface of the copper circuit plate has a larger thermal expansion coefficient than the ceramic substrate; hence, a crack is easily formed. The crack propagates disadvantageously to a portion of the blazing layer located at a lower portion of the copper circuit plate to reduce the bonding strength between the copper circuit plate and the ceramic board.

The present invention has been accomplished in light of the foregoing problems and aims to provide a circuit board with high bonding strength and an electronic device provided with the circuit board.

### Solution to Problem

A circuit board according to the present invention is according to claim 1.

An electronic device according to the present invention includes an electronic component on the circuit member of the circuit board with the foregoing structure. Advantageous Effects of Invention

The circuit board of the present invention has high bonding strength.

The electronic device of the present invention has good durability and high reliability.

### Brief Description of Drawings

Figs. 1(a) to 1(c) illustrate an example of a circuit board according to an embodiment, Fig. 1(a) being a plan view, Fig. 1(b) being a cross-sectional view taken along line A-A' of Fig. 1(a), and Fig. 1(c) being a micrograph of part of a surface of an exposed portion taken with a scanning electron microscope.
Figs. 2(a) and 2(b) illustrate another example of a circuit board according to the embodiment, Fig. 2(a) being a plan view, and Fig. 2(b) being a cross-sectional view taken along line B-B' of Fig. 2(a).
Figs. 3(a) and 3(b) illustrate yet another example of a circuit board according to the embodiment, Fig. 3(a) being a plan view, and Fig. 3(b) being a cross-sectional view taken along line C-C' of Fig. 3(a).
Figs. 4(a) to 4(c) illustrate still yet another example of a circuit board according to the embodiment, Fig. 4(a) being a plan view, Fig. 4(b) being a cross-sectional view taken along line D-D' of Fig. 4(a), and Fig. 4(c) being an enlarged view of a circuit member of Fig. 4(b).
Figs. 5(a) and 5(b) illustrates an example of an electronic device according to the embodiment, Fig. 5(a) being a plan view, and Fig. 5(b) being a cross-sectional view taken along ling E-E' of Fig. 5(a).

### Description of Embodiments

A circuit board and an electronic device according to an embodiment will be described with reference to the drawings. In the drawings, the same elements are designated using the same reference numerals.

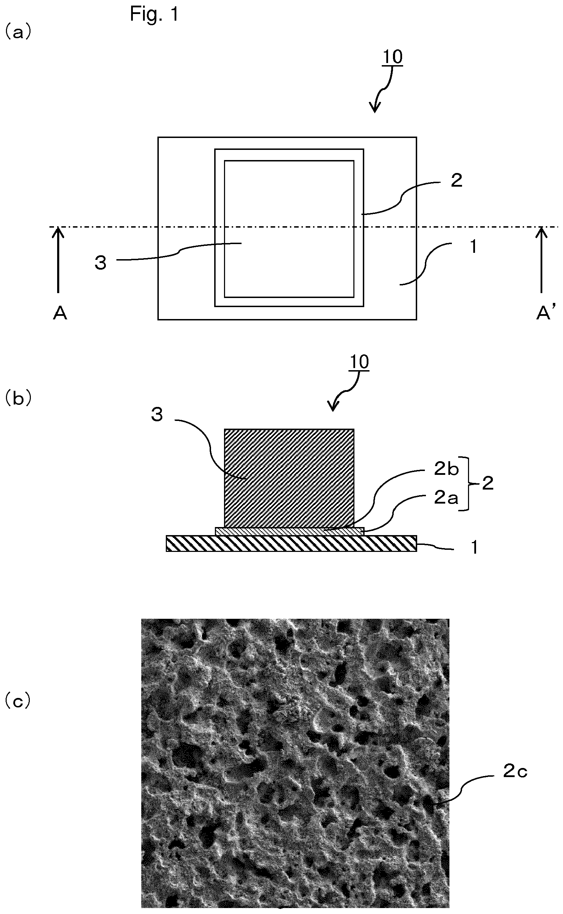

Figs. 1(a) to 1(c) illustrate an example of a circuit board according to the embodiment, Fig. 1(a) being a plan view, Fig. 1(b) being a cross-sectional view taken along line A-A' of Fig. 1(a), and Fig. 1(c) being a micrograph of part of a surface of an exposed portion taken with a scanning electron microscope.

A circuit board 10 according to the embodiment illustrated in Fig. 1 includes a ceramic substrate 1, a bonding layer 2, and a circuit member 3, the circuit member 3 being located on one main surface of the ceramic substrate 1 with the bonding layer 2 therebetween. The bonding layer 2 is formed by heat treatment of a brazing material and includes a mounting portion 2b with the circuit member 3 mounted thereon and an exposed portion 2a. The exposed portion 2a is a region of the bonding layer 2 other than the mounting portion 2b. The exposed portion 2a includes voids 2c on the surface, as illustrated in Fig. 1(c) which is a micrograph of part of a surface of the exposed portion 2a taken with a scanning electron microscope. The voids 2c are open on the surface of the exposed portion 2a and have desired depth.

The degree of dispersion of distances between centers of gravity (hereinafter, also referred to simply as a "degree of dispersion") of the voids 2c on the surface of the exposed portion 2a is 3 or more and 55 or less on average. When the average value of dispersion of the voids 2c on the surface of the exposed portion 2a is 3 or more and 55 or less, even if a crack is formed in the exposed portion 2a by a cool-heat cycle, the presence of the voids 2c inhibits the propagation of the crack. Thus, the circuit board 10 according to the embodiment has high bonding strength. The propagation of the crack is inhibited, so that the falling out of particles included in the exposed portion 2a is also inhibited. Thus, for example, a defect, such as a short circuit in a circuit, is also inhibited.

The degree of dispersion used here is determined by what is called a distance-between-center-of-gravity method and is a value obtained by dividing the standard deviation of distances between centers of gravity of the voids 2c by the average value of the distances between centers of gravity of the voids 2c. The degree of dispersion used here refers to an index of the degree of dispersion of the voids 2c. When the number of the voids 2c is constant, a low degree of dispersion indicates an equal distance between centers of gravity of the voids 2c and uniform dispersion of the voids 2c. A high degree of dispersion indicates variations in the distances between centers of gravity of the voids 2c and nonuniform dispersion of the voids 2c. The degree of dispersion is obtained by dividing the standard deviation of distances between centers of gravity of the voids 2c by the average value of the distances between centers of gravity of the voids 2c; hence, at a small number of the voids 2c and large distances between centers of gravity, the degree of dispersion indicates a low value.

At an average value of dispersion less than 3, the number of the voids 2c is small, and the distances between the voids 2c are large; hence, the effect of inhibiting the propagation of a crack is reduced. At an average value of dispersion more than 55, variations of the voids 2c are large; hence, the propagation of a crack is not inhibited in portions where the distances between the voids 2c are large.

With respect to the calculation of the average value of dispersion of the voids 2c, an image of a surface of the exposed portion 2a captured with a scanning electron microscope (SEM) may be analyzed by the distance-between-center-of-gravity method with image analysis software "A-zou kun" (registered trademark, developed by Asahi Kasei Engineering Corporation; when the image analysis software "A-zou kun" is described below, it indicates the image analysis software developed by Asahi Kasei Engineering Corporation).

In SEM observation, four to six portions in a region having an area of 1 × 10⁴ µm² to 4 × 10⁴ µm² (for example, 100 µm to 200 µm long in longitudinal and transverse directions) in a part of the exposed portion 2a where the voids 2c are averagely observed may be targeted at a magnification of ×200. With respect to setting conditions in this method, for example, the lightness may be set to be dark, a method of binarization may be set to be manual, the small geometrical figure removal area may be set to be 5 µm², and the threshold value serving as an index indicating the brightness of an image may be set to be 60.

In the setting conditions, the voids 2c each having a dimension of 2 µm or less are excluded. The maximum value of the voids 2c on the exposed portion 2a of the circuit board 10 is about 30 µm. The phrase "a part of the exposed portion 2a where the voids 2c are averagely observed" is a description to eliminate the fact that a specific region is intentionally selected.

The voids 2c have an average circle equivalent diameter of 4 µm or more and 12 µm or less. When the average circle equivalent diameter of the voids 2c is 4 µm or more and 12 µm or less, the propagation of a crack due to the cool-heat cycle is inhibited while high bonding strength is provided.

With respect to the calculation of the average circle equivalent diameter of the voids 2c, an image of a surface of the exposed portion 2a taken with the SEM may be analyzed by a particle analysis method with the image analysis software "A-zou kun". A region observed and setting conditions may be the same as those in measurement of the circle equivalent diameter of the voids 2c.

An example in which the circuit board according to the embodiment includes circuit members will be described below.

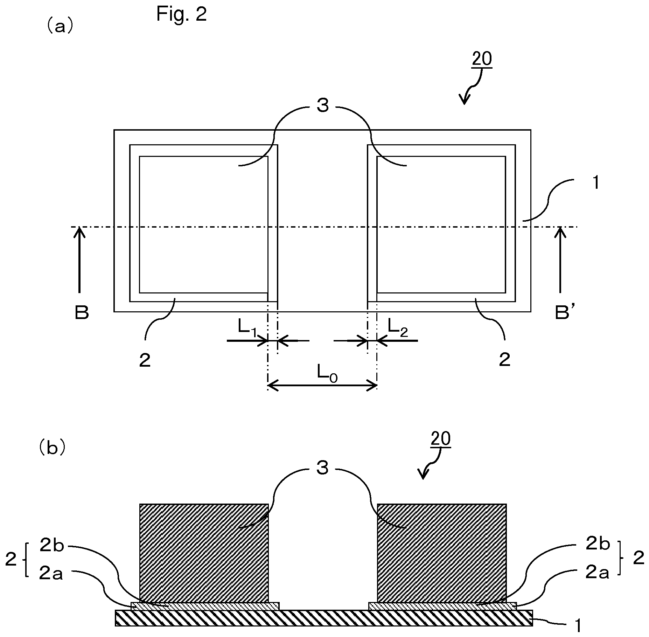

Figs. 2(a) and 2(b) illustrate another example of a circuit board according to the embodiment, Fig. 2(a) being a plan view, and Fig. 2(b) being a cross-sectional view taken along line B-B' of Fig. 2(a).

In a circuit board 20 according to the embodiment, pairs of the circuit members 3 and the bonding layer 2 are located on one main surface of the ceramic substrate 1. This structure is preferred in view of multifunctionality and space saving, compared with the circuit board 10 illustrated in Fig. 1.

In this structure, the proportion of the total of lengths L₁ and L₂ of the exposed portions 2a between two neighboring end faces of the circuit members 3 is preferably 25% or more and 38% or less with respect to a length L₀ between the end faces.

When the proportion of the total of the lengths L₁ and L₂ of the exposed portions 2a between the two neighboring end faces of the circuit members 3 is 25% or more and 38% or less with respect to the length L₀ between the two neighboring end faces, improvement in bonding strength and the inhibition of the propagation of a crack due to the cool-heat cycle are achieved between the end faces of the circuit members 3 while the occurrence of creeping discharge along a main surface of the ceramic substrate 1 is inhibited, because the exposed portions 2a lie. Thereby, the reliability of the circuit board 20 is improved. The length L₀ between the two neighboring end faces of the circuit members 3 is, for example, 0.8 mm or more and 2.2 mm or less.

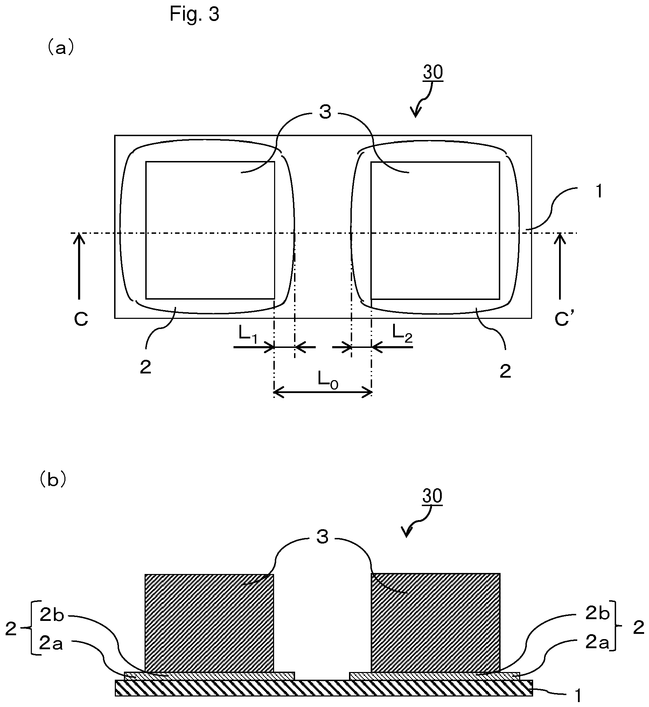

Figs. 3(a) and 3(b) illustrate yet another example of a circuit board according to the embodiment, Fig. 3(a) being a plan view, and Fig. 3(b) being a cross-sectional view taken along line C-C' of Fig. 3(a).

As illustrated in Fig. 3, a circuit board 30 according to the embodiment includes the bonding layers 2 each having a different shape from that of the circuit board 20 illustrated in Fig. 2 when viewed in plan. When the bonding layers 2 have the shape as illustrated in Fig. 3, the lengths L₁ and L₂ of the exposed portions 2a may be determined by measuring the length of each exposed portion 2a at a position where the shortest distance between the exposed portions 2a is obtained between the end faces.

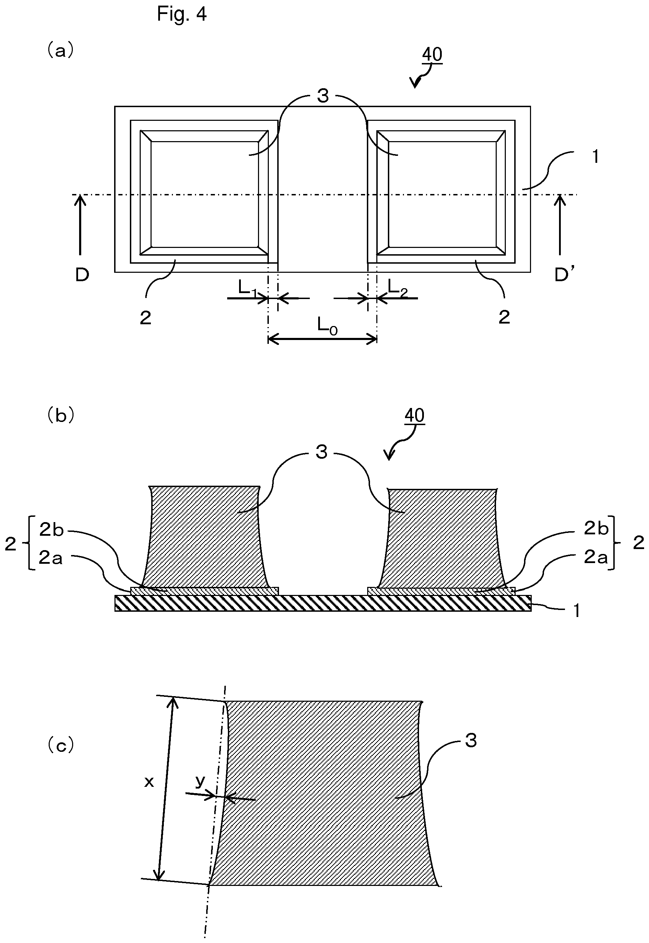

Figs. 4(a) to 4(c) illustrate still yet another example of a circuit board according to the embodiment, Fig. 4(a) being a plan view, Fig. 4(b) being a cross-sectional view taken along line D-D' of Fig. 4(a), and Fig. 4(c) being an enlarged view of a circuit member of Fig. 4(a).

As illustrated in Fig. 4, a circuit board 40 according to the embodiment includes the circuit members 3 each having a rectangular shape in plan and each having a prismoid-like structure in which four end faces of each circuit member 3 are curved. The remaining components are the same as those of the circuit board 20.

As illustrated in Fig. 4, when the end faces of the circuit members 3 are curved, the length L₀ between two neighboring end faces of circuit members 3 may be defined as a length at a position where the shortest distance between the circuit members 3 is obtained.

The degree of curvature of each of the end faces of the circuit members 3 is preferably 8% or more and 22% or less. As illustrated in Fig. 4(c), letting the length of a straight line that connects both edges of each of the curved end faces be x, and letting the length between the straight line and the most curved portion in the direction normal to the straight line be y, the degree of curvature used here is a value represented by the following formula: y/x × 100. The degree of curvature may be determined by using an image of a side surface or a cross section of each circuit member 3, the image being taken with an optical microscope or the like at a magnification of ×100 or more and ×200 or less.

When the degree of curvature is 8% or more and 22% or less, stresses concentrated on portions of the ceramic substrate 1 located on extensions of the end faces of the circuit members 3 may be relieved with heat dissipation characteristics maintained. Thus, a crack is less likely to be formed.

Materials in the circuit board according to the embodiment will be described below using reference numerals used in Fig. 1.

The bonding layer 2 preferably contains 50% by mass or more of silver and copper with respect to 100% by mass of the total components in the bonding layer 2. The bonding layer 2 preferably contains element A that is one selected from indium, zinc, and tin and element B that is one selected from titanium, zirconium, hafnium, and niobium.

Element A in the bonding layer 2 is a component in a brazing material to be formed into the bonding layer 2. At least one element A selected from indium, zinc, and tin melts easily because of its low melting point, achieving good flowability during bonding. Thus, gaps formed between the bonding layer 2 and the ceramic substrate 1 or between the bonding layer 2 and the circuit member 3 are reduced. The presence or absence of the gaps may be examined by an ultrasonic flaw detection method.

Element B in the bonding layer 2 is a component in the brazing material to be formed into the bonding layer 2. At least one element B selected from titanium, zirconium, hafnium, and niobium has good wettability with the ceramic substrate 1 and the circuit member 3. The reaction between a component in the ceramic substrate 1 and element B allows the ceramic substrate 1 and the circuit member 3 to be tightly bonded together. The bonding strength between the ceramic substrate 1 and the circuit member 3 may be determined by measuring the peel strength in accordance with JIS C 6481-1996 (IEC 249-1 (1982)).

The bonding layer 2 may further contain at least one element C selected from molybdenum, tantalum, osmium, rhenium, and tungsten, in addition to silver, copper, element A, and element B.

When the bonding layer 2 contains element C, in other words, when the brazing material contains element C, the at least one element C selected from molybdenum, osmium, rhenium, and tungsten does not melt easily because of its high melting point, inhibiting an excessive decrease in the viscosity of the brazing material during bonding. This inhibits unwanted protrusions, such as excessive expansion of the exposed portion 2a and connection to another bonding layer.

To achieve the reduction of the gaps formed between the bonding layer 2 and the ceramic substrate 1 or between the bonding layer 2 and the circuit member 3, tight bonding between the ceramic substrate 1 and the circuit member 3, and inhibition of unwanted protrusion, preferably, the bonding layer 2 contains silver, copper, element A, element B, and element C and has a copper content of 35% by mass or more and 50% by mass or less, an element A content of 0.5% by mass or more and 22% by mass or less, an element B content of 1% by mass or more and 8% by mass or less, and an element C content of 9.5% by mass or more and 11.5% by mass or less, with the balance being silver, with respect to 100% by mass of the total contents thereof. The mounting portion 2b of the bonding layer 2 is examined for identification of components in the bonding layer 2 and determination of their contents with an X-ray fluorescence analyzer (XRF) or inductively coupled plasma (ICP) emission spectrometer.

In the circuit board 10 according to the embodiment, the circuit member 3 contains a metal component as a main component. The main component of the circuit member 3 according to the embodiment refers to a component contained in an amount of 70% by mass or more with respect to 100% by mass of the total components in the circuit member 3.

More specifically, copper is preferably used. The circuit member 3 is preferably composed of any of oxygen-free copper, tough pitch copper, and phosphorus-deoxidized copper, each having a copper content as high as 90% by mass or more. In particular, among oxygen-free coppers, any of linear-crystal oxygen-free copper, high-purity single-crystal oxygen-free copper, and vacuum melting copper each having a copper content of 99.995% by mass or more is preferred. As described above, when the circuit member 3 is composed of a material with a high copper content, the circuit member 3 has good heat dissipation characteristics owing to its high thermal conductivity and has good circuit characteristics (characteristics that inhibit heat generation of an electronic component to reduce power dissipation) owing to its low electrical resistance. Furthermore, a higher copper content results in lower yield stress and easier plastic deformation upon heating, thereby increasing the bonding strength of the circuit member 3 to improve the reliability.

The ceramic substrate 1 used in the circuit board 10 according to the embodiment is preferably composed of, for example, any of a sintered silicon nitride-based member, a sintered aluminum nitride-based member, a sintered boron nitride-based member, a sintered silicon carbide-based member, a sintered boron carbide-based member, a sintered aluminum oxide-based member, and a sintered zirconium oxide-based member. To take the sintered silicon nitride-based member as an example, the sintered silicon nitride-based member refers to a sintered member containing silicon nitride as a main component. The main component used here refers to a component contained in an amount of 70% by mass or more with respect to 100% by mass of the total components in the sintered member.

As the ceramic substrate 1 used in the circuit board 10 according to the embodiment, a sintered silicon nitride-based member is preferably used because of its high breakdown voltage and thermal shock resistance.

Preferably, the ceramic substrate 1 is composed of a sintered silicon nitride-based member, and 50 or more and 200 or less white spots per square millimeter are present, the white spots each having a circle equivalent diameter of 2 µm or more and 30 µm or less. When the structural requirements are satisfied, the white spots are infiltrated with a metal component in the brazing material to be formed into the bonding layer 2 during bonding to provide a strong anchoring effect, thereby increasing the bonding strength. In the foregoing structure, the amount of the metal component infiltrated into the white spots is small, and the ceramic substrate 1 has high dielectric strength. Thus, while the breakdown of the circuit board 10 is less likely to occur, the circuit board 10 has high bonding strength to the circuit member 3.

In the foregoing structure, an average distance between two neighboring white spots is preferably 4 µm or more.

When this structural requirement is satisfied, discharge due to the metal component infiltrated into the white spots is inhibited, thereby inhibiting a reduction in dielectric strength. The average distance between two neighboring white spots refers to a value obtained by determining the average distance between centers of gravity of the white spots and the average circle equivalent diameter of the white spots in a measurement range and then subtracting the average circle equivalent diameter from the average distance between centers of gravity.

The degree of irregularity of each of the white spots is preferably 1.1 or more and 2.9 or less. The degree of irregularity refers to the degree of irregularity of the outline of each white spot. A higher degree of irregularity indicates a larger number of irregularities on the outline. When the degree of irregularity of each white spot is 1.1 or more and 2.9 or less, the bonding strength to the circuit member 2 is improved while the occurrence of chipping from the outline of the white spot is inhibited at the time of, for example, the application of the brazing material used for the bonding of the circuit member 2.

Each of the white spots preferably has a circularity of 0.7 or more and 0.9 or less. At higher circularity, the outline of each white spot is closer to a perfect circle. The perfect circle has a circularity of 1. When each white spot has a circularity of 0.7 or more and 0.9 or less, the bonding strength to the circuit member 2 is improved while the occurrence of chipping from the outline of the white spot is inhibited at the time of, for example, the application of the brazing material used for the bonding of the circuit member 2.

A method for determining the number of the white spots, each having a circle equivalent diameter of 2 µm or more and 30 µm or less, per square millimeter, and the degree of irregularity and the circularity of each of the white spots will be described below. A main surface of the ceramic substrate 1 is polished into a mirror finish. The mirror-finished surface is used as a measuring surface and observed with an optical microscope at a magnification of ×100. For example, a region with an area of 1.2 mm² (a transverse length of 1.2 mm and a longitudinal length of 1 mm) is photographed with a CCD camera in a dark field. The captured image is analyzed by the particle analysis method with the image analysis software "A-zou kun" to determine the number of the white spots per area of 1.2 mm², each of the white spots having a circle equivalent diameter of 2 µm or more and 30 µm or less, and the degree of irregularity and the circularity of each of the white spots. The resulting number of the white spots may be converted into the number of the white spots, each having a circle equivalent diameter of 2 µm or more and 30 µm or less, per square millimeter.

The average distance between two neighboring white spots is determined as follows: The same image as that described above is analyzed by the particle analysis method with the image analysis software "A-zou kun" to determine the average circle equivalent diameter of the white spots and then by the distance-between-center-of-gravity method to determine the average distance between centers of gravity of the white spots. The average circle equivalent diameter of the white spots is subtracted from the average distance between centers of gravity of the white spots to determine the average distance between two neighboring white spots.

With respect to setting conditions in each of the particle analysis method and the distance-between-center-of-gravity method, for example, the lightness may be set to be light, a method of binarization may be set to be manual, the small geometrical figure removal area may be set to be 0 µm², and the threshold value serving as an index indicating the brightness of an image may be set to be 1 or more and 1.4 or less times the peak maximum in a histogram indicating the brightness of points (pixels) in the image.

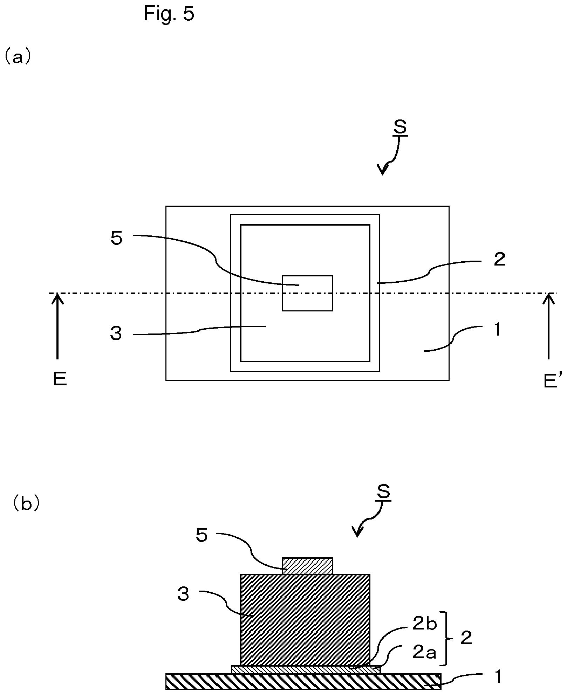

An electronic device according to the embodiment will be described below with reference to Fig. 5.

Figs. 5(a) and 5(b) illustrates an example of an electronic device according to the embodiment, Fig. 5(a) being a plan view, and Fig. 5(b) being a cross-sectional view taken along ling E-E' of Fig. 5(a).

An electronic device S in the example illustrated in Fig. 5 is one in which an electronic component 5, such as a semiconductor element, is mounted on the circuit member 3 of the circuit board 10 according to the embodiment.

The electronic device S has high reliability because the electronic component 5 is mounted on the circuit member 3 strongly bonded to the circuit board 10. Fig. 5 illustrates an example in which one circuit member 3 is used. However, as illustrated in Figs. 2 to 4, the multiple circuit members 3 may be used.

A method of producing a circuit board according to the embodiment will be described below with reference to Fig. 1.

To produce the circuit board 10 in the example illustrated in Fig. 1, the ceramic substrate 1 and a block, containing copper as a main component, to be formed into the circuit member 3 are prepared. A paste-like, silver (Ag)-copper (Cu)-based-alloy brazing material containing at least one element A selected from indium, zinc, and tin and at least one element B selected from titanium, zirconium, hafnium, and niobium is prepared.

The brazing material may further contain at least one element C selected from molybdenum, tantalum, osmium, rhenium, and tungsten.

Regarding the bonding layer 2 formed by another treatment of the brazing material, in order to form the bonding layer 2 containing silver, copper, element A, element B, and element C and having a copper content of 35% by mass or more and 50% by mass or less, an element A content of 0.5% by mass or more and 22% by mass or less, an element B content of 1% by mass or more and 8% by mass or less, and an element C content of 9.5% by mass or more and 11.5% by mass or less, with the balance being silver, with respect to 100% by mass of the total contents of silver, copper, element A, element B, and element C, the brazing material may have the same mass composition as that of the bonding layer 2.

The brazing material is applied to a main surface of the ceramic substrate 1 by any of a screen printing method, a roll coating method, and a brush coating method. The block, containing copper as a main component, to be formed into the circuit member 3 is arranged on the brazing material. The resulting article is heated to 800°C or higher and 900°C or lower in a vacuum atmosphere while being pressed at a pressure of 30 MPa or more, thereby bonding the block to the ceramic substrate 1.

A resist is applied by printing on a desired portion of a main surface of the block so as to occupy an area smaller than that of the applied brazing material. The resist is dried at 120°C or higher and 150°C or lower and etched with, for example, nitric sulfuric hydrofluoric acid, nitric hydrofluoric acid, hydrochloric acid, or an aqueous solution of ferric chloride to remove a portion of the block where the resist is not applied by printing, thereby forming the circuit member 3. A portion of the bonding layer 2 where the removed portion of the block has been located functions as the exposed portion 2a. The resist is removed with an aqueous alkaline solution, for example, an aqueous solution of sodium hydroxide or an aqueous solution of potassium hydroxide, and washed to produce the circuit board 10 according to the embodiment.

To produce the circuit board 10 including the voids 2c on the surface of the exposed portion 2a, the average value of dispersion of the voids 2c being 3 or more and 55 or less, the etching temperature may be 40°C or higher and 50°C or lower, and the etching time may be 60 minutes or more and 110 minutes or less.

To produce the circuit board 10 including the voids 2c having an average circle equivalent diameter of 4 µm or more and 12 µm or less, the etching temperature may be the same temperature as that described above, and the etching time may be 70 minutes or more and 100 minutes or less.

The circuit boards 10 according to the embodiment may be easily produced by preparing a substrate large enough to be divided into the ceramic substrates 1, applying the brazing material to desired portions thereof, bonding blocks to the portions, each of the blocks containing copper as a main component and being large enough to cover a corresponding one of the portions of the brazing material, applying a resist to a desired portion of a main surface of each of the blocks by printing, performing etching, and dividing the substrate by cutting. The circuit boards 20 to 40 according to the embodiment may be produced by changing the number of the circuit members 3 bonded to the ceramic substrate 1, the shape of the portions of the brazing material applied when viewed in plan, and the form of the blocks bonded.

The circuit member 3 has a thickness of, for example, 0.5 mm or more and 5 mm or less. The mounting portion 2b of the bonding layer 2 has a thickness of, for example, 5 µm or more and 60 µm or less.

The position of the brazing material applied and the positions of the resist applied by printing on the main surfaces of the blocks may be adjusted in order that pairs of the circuit member 3 and the bonding layer 2 may be located on a main surface of the ceramic substrate 1 and the total length of the exposed portion 2a may be 25% or more and 38% or less of a length between two neighboring end faces of the circuit members 3.

An example in which the ceramic substrate 1 is composed of a sintered silicon nitride-based member (hereinafter, referred to as a "silicon nitride-based substrate") will be described below. To form the silicon nitride-based substrate including 50 or more and 200 or less white spots per square millimeter, each of the white spots having a circle equivalent diameter of 2 µm or more and 30 µm or less, a powder of silicon nitride having a β-phase content of 20% or less and a purity of 98% or more and powders serving as additive components of magnesium oxide (MgO) and a rare-earth metal oxide (for example, at least one of Sc₂O₃, Y₂O₃, La₂O₃, Ce₂O₃, Pr₆O₁₁, Nd₂O₃, Pm₂O₃, Sm₂O₃, Eu₂O₃, Gd₂O₃, Tb₂O₃, Dy₂O₃, Ho₂O₃, Er₂O₃, Tm₂O₃, Yb₂O₃, and Lu₂O₃) are wet-mixed and pulverized with water using a mixing device, for example, a barrel mill, a tumbling mill, a vibrating mill, a bead mill, a sand mill, or an agitator mill, thereby preparing a slurry.

With respect to specific amounts fed, the amount of the powder of magnesium oxide added is 1% by mass or more and 2% by mass or less, the amount of the powder of the rare-earth metal oxide added is 2% by mass or more and 4% by mass or less, and the balance is the powder of silicon nitride.

To form the silicon nitride-based substrate including 50 or more and 200 or less white spots per square millimeter, each of the white spots having a circle equivalent diameter of 2 µm or more and 30 µm or less, a calcium powder may be added in such a manner that the silicon nitride-based substrate has a calcium content of 2 ppm by mass or more and 100 ppm by mass or less.

To form the silicon nitride-based substrate in which the average distance between two neighboring white spots is 4 µm or more, 2.5 parts by mass of a dispersant may be added with respect to 100 parts by mass of the total of the powder of silicon nitride and the powders of the additive components.

To form the silicon nitride-based substrate in which the degree of irregularity of each of the white spots is 1.1 or more and 2.9 or less, the mixing and pulverizing time with the mixing device may be, for example, 24 hours or more and 72 hours or less. To form the silicon nitride-based substrate in which each of the white spots has a circularity of 0.7 or more and 0.9 or less, the mixing and pulverizing time with the mixing device may be, for example, 36 hours or more and 60 hours or less.

As another example of amounts fed, the amount of the powder of magnesium oxide added is 2% by mass or more and 6% by mass or less, the amount of the powder of the rare-earth metal oxide added is 12% by mass or more and 16% by mass or less, the amount of the powder of aluminum oxide added is 0.1% by mass or more and 0.5% by mass or less, and the balance is the powder of silicon nitride.

The resulting slurry and an organic binder are mixed together and spray-dried to form granules containing silicon nitride as a main component. The granules are formed into a ceramic green sheet by a powder rolling process. The ceramic green sheet is cut into pieces with a predetermined length, thereby providing formed articles. When a pressure forming process is used in place of the powder rolling process, the silicon nitride-based granules are charged into a forming die and pressed to provide a formed article.

Each of the resulting formed articles is placed in a sagger composed of a sintered silicon nitride-based member and fired in a firing furnace with a graphite heating element. At this time, the evaporation of components in the formed article is inhibited by arranging 2 parts by mass or more and less than 10 parts by mass of a common material around the formed article with respect to 100 parts by mass of the formed article, the common material having a composition close to that of the formed article, and then performing firing.

Firing conditions are as follows: The formed article is heated from room temperature to 300°C to 1000°C in a vacuum atmosphere. Nitrogen gas is then introduced, and the nitrogen partial pressure is maintained at 15 to 900 kPa. The formed article is further heated, held at 1640°C or higher and 1750°C or less for 4 hours or more and 10 hours or less, and cooled at a rate of temperature decrease of 170 °C/hour or higher and 230 °C/hour or lower, thereby forming the silicon nitride-based substrate including 50 or more and 200 or less white spots per square millimeter, each of the white spots having a circle equivalent diameter of 2 µm or more and 30 µm or less.

While the circuit boards 10 to 40 each including the circuit member(s) 3 on the one main surface of the ceramic substrate 1 and the electronic device S according to the embodiments have been described, a heat-dissipating member may be located on the other main surface of the ceramic substrate 1.

While examples of the embodiments will be specifically described below, the embodiments are not limited to these examples.

### EXAMPLE 1

Silicon nitride-based substrates were prepared. Blocks to be formed into circuit members were prepared. A paste-like silver (Ag)-copper (Cu)-based alloy brazing material containing tin, titanium, and molybdenum was prepared. Regarding the silver, copper, tin titanium, and molybdenum contents, the brazing material has a silver content of 51.9% by mass, a copper content of 40% by mass, a tin content of 2.6% by mass, and a titanium content of 2.5% by mass, and a molybdenum content of 3.0% by mass with respect to 100% by mass of the total contents of these elements.

The silicon nitride-based substrates were heat-treated at 850°C to remove organic matter and residual carbon adhering to surfaces of the silicon nitride-based substrates. The prepared brazing material was applied to one main surface of each of the silicon nitride-based substrates by a screen printing method. The blocks, composed of oxygen-free copper, to be formed into circuit members were arranged on the brazing material. The resulting articles were heated to 840°C in a vacuum atmosphere while being pressed at a pressure of 30 MPa, thereby bonding the block to the silicon nitride-based substrates.

A resist was applied by printing to a desired portion of a main surface of each of the blocks and dried at 140°C. Etching was performed with an aqueous solution containing 28.4% by mass to 32.4% by mass of ferric chloride. The etching temperature was 45°C. The etching time was set as listed in Table 1. The resist is removed with an aqueous solution of sodium hydroxide to form samples 1 to 7 each including one circuit member located on the one main surface of the corresponding silicon nitride-based substrate. The structure in plan is the same as that of the circuit member illustrated in Fig. 1. The length of an exposed portion from an end face of the circuit member was 0.2 mm.

To determine the average value of dispersion of voids on each exposed portion, five portions in a region having an area of 4 × 10⁴ µm² (200 µm long in longitudinal and transverse directions) in a part of the exposed portion where the voids were averagely observed were selected with a SEM at a magnification of ×200 and analyzed by a distance-between-center-of-gravity method with image analysis software "A-zou kun" to determine the average value of dispersion of the voids. Similarly, an analysis was performed by a particle analysis method with the image analysis software "A-zou kun". The average circle equivalent diameter of the voids obtained by the analysis was described in Table 1.

With respect to setting conditions in the analyses, the lightness of particles was set to be dark, a method of binarization was set to be manual, the small geometrical figure removal area was set to be 5 µm², and the threshold value serving as an index indicating the brightness of an image was set to be 60.

In each of the samples, the circuit board was subjected to a heat-cycle test. One cycle was as follows: the temperature was lowered from room temperature to -45°C, held for 15 minutes at the temperature, raised to 125°C, held for 15 minutes at the temperature, and lowered to room temperature. After 3500 cycles, the length of the longest crack on the surface of the exposed portion was measured with an optical microscope at a magnification of ×100. The value was described in Table 1.

**[Table 1]**

| Sample No. | Etching time (min) | Average degree of dispersion of voids | Average circle equivalent diameter of voids (µm) | Crack length (mm) |
|---|---|---|---|---|
| 1 | 59 | 2.0 | 2.8 | >0.200 |
| 2 | 60 | 3.0 | 3.6 | 0.098 |
| 3 | 70 | 13.4 | 4.0 | 0.046 |
| 4 | 85 | 29.0 | 8.0 | 0.051 |
| 5 | 100 | 44.6 | 12.0 | 0.056 |
| 6 | 110 | 55.0 | 14.7 | 0.102 |
| 7 | 135 | 81.0 | 21.4 | >0.200 |

As listed in Table 1, the longest crack in each of samples 2 to 6 after the 3500 cycles had a length smaller than those of samples 1 and 7. This indicated that when the average value of dispersion of the voids was 3 or more and 55 or less, the propagation of the crack was inhibited even if the crack was subjected to the heat cycle.

Furthermore, the longest crack in each of samples 3 to 5 after the 3500 cycles had a length smaller than those of samples 2 and 6. This indicated that when the average circle equivalent diameter of the voids was 4 µm or more and 12 µm or less, the propagation of the crack was further inhibited.

To examine the bonding strength between the circuit members and the silicon nitride-based substrates in samples 1 to 7, the peel strength of the samples after the 3500 heat cycles was measured in accordance with JIS C 6481-1996. As a result, samples 2 to 6 had good results, compared with samples 1 and 7.

### EXAMPLE 2

Samples 8 to 12 were produced in the same way as in Example 1, except that two blocks to be formed into circuit members were prepared, lengths between end faces of the circuit members, lengths of the exposed portions, and so forth were set as listed in Table 2, the etching temperature was 45°C, and the etching time was 80 minutes. The average value of dispersion of the voids in the exposed portion was 29.0.

Values of the lengths L₀ between the end faces of the circuit members and the lengths L₁ and L₂ of the exposed portions listed in Table 2 were measured with an optical microscope at a magnification of ×100.

A heat-cycle test was performed for 3500 cycles in the same way as in Example 1. Then the peel strength was measured in accordance with JIS C 6481-1996. The dielectric breakdown strength between two neighboring circuit members was measured in accordance with JIS C 2110-1:2010. Table 2 lists the results.

**[Table 2]**

| Sample No. | Spacing L₀ (mm) | Length L₁ (mm) | Length L₂ (mm) | (L₁+L₂)/L₀×100 (%) | Peel strength (kN/m) | Dielectric breakdown strength (MV/m) |
|---|---|---|---|---|---|---|
| 8 | 1 | 0.115 | 0.115 | 23 | 28 | 10.0 |
| 9 | 1 | 0.125 | 0.125 | 25 | 30 | 9.8 |
| 10 | 1 | 0.16 | 0.16 | 32 | 31 | 9.6 |
| 11 | 1 | 0.19 | 0.19 | 38 | 32 | 9.4 |
| 12 | 1 | 0.2 | 0.2 | 40 | 34 | 8.4 |

As listed in Table 2, each of samples 9 to 11 had a greater peel strength than that of sample 8 and a greater dielectric breakdown strength than that of sample 12. The results indicated that when the proportion of the total length of the exposed portions between the two neighboring end faces of the circuit members is 25% or more and 38% or less with respect to the length between the end faces, the circuit board had high reliability.

### EXAMPLE 3

Two blocks were bonded to each of silicon nitride-based substrates with brazing materials such that bonding layers had silver, copper, element A, element B, and element C contents listed in Table 3 with respect to 100% by mass of the total contents of these elements in each of the bonding layers. The same application conditions, such as the amount applied, for the brazing materials and the same bonding conditions (in a vacuum atmosphere at 850°C under a pressing pressure of 40 MPa) were used.

The protruding length, the voidage, and the peel strength were evaluated. Regarding the protruding length, samples 22 and 23 having the maximum distance between the bonding layers were used as a reference. The difference between a reference value and the distance between the bonding layers was described in Table 3.

The voidage was calculated from Sᵥ/Sₒ × 100 where Sₒ represents the area of the main surface of each of the circuit members bonded to the silicon nitride-based substrate, and Sᵥ represents the total area of the voids per area Sₒ, the voids being present between the silicon nitride-based substrate and the bonding layer. Sᵥ may be determined by an ultrasonic flaw detection method. Measurement conditions for the ultrasonic flaw detection method included a flaw-detecting frequency of 50 MHz, a gain of 30 dB, and a scan pitch of 100 µm.

The peel strength was measured in accordance with JIS C 6481-1996.

Identification of elements in the bonding layer and determination of their contents were performed by XRF. Table 3 lists the results.

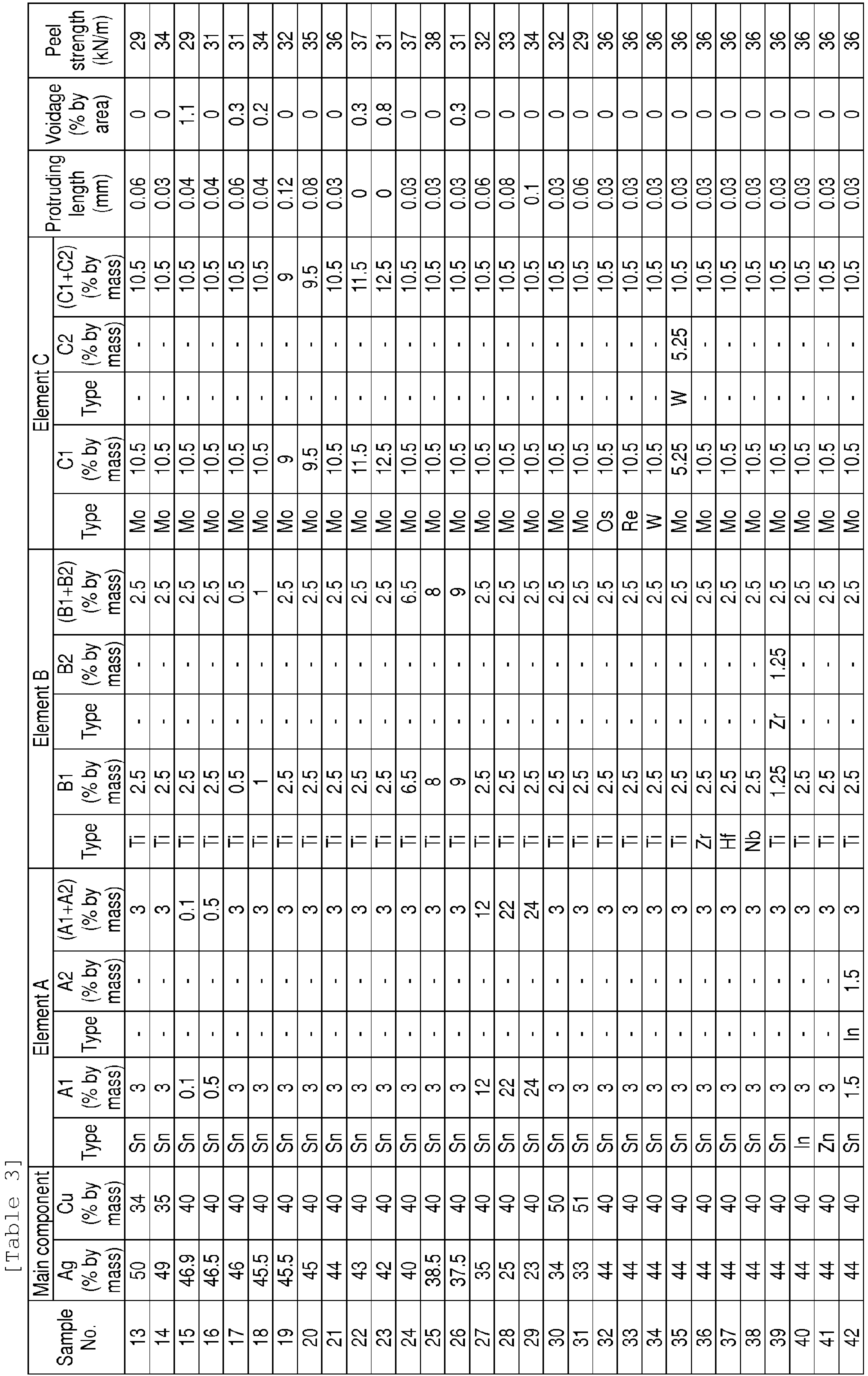

As listed in Table 3, a comparison among samples 19 to 23 in which element A, element B, and element C were, respectively, tin, titanium, and molybdenum, and the element A content and the element B content were equal to each other and different from the element C content, revealed that each of samples 20 to 22 had only a small protrusion of the bonding layer and only a small number of the voids between the silicon nitride-based substrate and the bonding layer.

A comparison among samples 17, 18, 21, and 24 to 26 in which element A, element B, and element C were, respectively, tin, titanium, and molybdenum, and the element A content and the element C content were equal to each other and different from the element B content, revealed that each of samples 18, 21, 24, and 25 had high bonding strength.

A comparison among samples 15, 16, 21, and 27 to 29 in which element A, element B, and element C were, respectively, tin, titanium, and molybdenum, and the element B content and the element C content were equal to each other and different from the element A content, revealed that each of samples 16, 21, 27, and 28 had only a small protrusion of the bonding layer.

The results indicated that in order to produce the bonding layer having only a small protrusion, only a small amount of the voids, and high bonding strength, an element A content of 0.5% by mass or more and 22% by mass or less, an element B content of 1% by mass or more and 8% by mass or less, and an element C content of 9.5% by mass or more and 11.5% by mass or less are preferred.

A comparison among samples 13, 14, 21, 30, and 31 in which element A, element B, and element C were, respectively, tin, titanium, and molybdenum, and the element A content, the element B content, and the element C content were equal to one another and different from the copper content, revealed that each of samples 13, 21, and 30 had no void and sufficient bonding strength, and only a small protrusion and that the copper content was preferably 35% by mass or more and 50% by mass or less.

### EXAMPLE 4

A powder of silicon nitride having a β-phase content of 10% (that is, an α-phase content of 90%) and a purity of 98% and powders serving as additive components of magnesium oxide (MgO), erbium oxide (Er₂O₃), aluminum oxide (Al₂O₃), and molybdenum oxide (MoO₃) were wet-mixed together with a tumbling mill. The mixing and pulverization were performed until the particle diameter (D₉₀) was 1 µm or less, thereby preparing a slurry. A calcium powder was also added in such a manner that calcium contents listed in Table 4 were satisfied.

The powders were weighed in such a manner that a magnesium content of 2.5% by mass in terms of oxide (MgO), an erbium content of 14% by mass in terms of oxide (Er₂O₃), an aluminum content of 0.3% by mass in terms of oxide (Al₂O₃), and a molybdenum content of 0.5% by mass in terms of oxide (MoO₃) were obtained with respect to 100% by mass of the total components in a sintered member.

The resulting slurry and an organic binder were mixed together and spray-dried to form silicon nitride-based granules. The silicon nitride-based granules were formed into a ceramic green sheet by a powder rolling process. The ceramic green sheet was cut into pieces with a predetermined length, thereby providing flat plate-like formed articles.

Each of the resulting formed articles was placed in a sagger composed of a sintered silicon nitride-based member and fired in a firing furnace with a graphite heating element. At this time, the firing was performed while 6 parts by mass of a common material (containing components, such as silicon nitride, magnesium oxide, and a rare-earth metal oxide) was arranged with respect to 100 parts by mass of each formed article.

Firing conditions are as follows: The formed article was heated from room temperature to 1000°C in a vacuum atmosphere. Nitrogen gas was then introduced, and the nitrogen partial pressure was maintained at 100 kPa. The temperature in the firing furnace was raised. The formed article was held at 1690°C for 5 hours and cooled at a rate of temperature decrease of 200 °C/hour, thereby forming a silicon nitride-based substrate.

The number of white spots, each having a circle equivalent diameter of 2 µm or more and 30 µm or less, per square millimeter in each sample was measured as follows: A main surface was polished into a mirror finish. The mirror-finished surface was used as a measuring surface and observed with an optical microscope at a magnification of ×100. A region with an area of 1.2 mm² (a transverse length of 1.2 mm and a longitudinal length of 1 mm) was photographed with a CCD camera in a dark field. The captured image was analyzed by a particle analysis method with image analysis software "A-zou kun" to count the number of white spots. The resulting number of the white spots was converted into the number of the white spots per square millimeter.

With respect to setting conditions in this method, the lightness was set to be light, a method of binarization was set to be manual, the small geometrical figure removal area was set to be 0 µm², and the threshold value serving as an index indicating the brightness of an image was set to be 1.2 times the peak maximum in a histogram indicating the brightness of points (pixels) in the image.

To evaluate the dielectric strength of each sample, the dielectric breakdown strength (MV/m) of each sample was measured in accordance with JIS C 2141-1992 (IEC 672-2(1980)). Table 1 lists the resulting values. Electrodes formed on the samples were composed of brass. Silicone oil was used as a medium surrounding the samples.

Circuit boards were produced with the silicon nitride-based substrates serving as the samples in the same way as in sample 4 of Example 1. The bonding strength was evaluated by measuring the peel strength (kN/m) between each of the silicon nitride-based substrates and a corresponding one of the circuit members in accordance with JIS C 6481-1996. Table 4 lists the results.

**[Table 4]**

| Sample No. | Calcium content (ppm by mass) | Number of white spots (counts/mm²) | Dielectric breakdown strength (MV/m) | Peel strength (kN/ms) |
|---|---|---|---|---|
| 43 | 1 | 48 | 28 | 28 |
| 44 | 2 | 50 | 28 | 35 |
| 45 | 10 | 62 | 28 | 35 |
| 46 | 30 | 93 | 27 | 37 |
| 47 | 50 | 123 | 27 | 37 |
| 48 | 100 | 200 | 26 | 39 |
| 49 | 120 | 231 | 19 | 39 |

As listed in Table 4, in each of samples 44 to 48, while the silicon nitride-based substrate had high dielectric strength, the bonding strength between the silicon nitride-based substrate and the circuit member was high. This indicated that in the silicon nitride-based substrate, 50 or more and 200 or less white spots, each having a circle equivalent diameter of 2 µm or more and 30 µm or less, per square millimeter are preferably present.

### EXAMPLE 5

As with Example 4, a silicon nitride powder, a magnesium oxide powder, an erbium oxide powder, an aluminum oxide powder, and a molybdenum oxide powder, serving as additive components, were used. These powders were weighed in such a manner that the same contents as those in Example 4 were obtained. A calcium powder was also added in such a manner that the resulting silicon nitride-based substrate had a calcium content of 5 ppm. These powders were wet-mixed together with a tumbling mill. The mixture was pulverized until the particle diameter (D₉₀) was 1 µm or less, thereby preparing a slurry. Prior to the pulverization, the amount of a dispersant (a carboxy group-containing water-soluble polymer) described in Table 5 was added with respect to 100 parts by mass of the total of the silicon nitride powder and the additive component powders. The subsequent steps were performed in the same way as in Example 4 to form the silicon nitride-based substrate.

The average distance between two neighboring white spots was determined as follows: An image was captured in the same way as in Example 4. The image was analyzed by the particle analysis method with the image analysis software "A-zou kun" to determine the average circle equivalent diameter of the white spots and then by the distance-between-center-of-gravity method to determine the average distance between centers of gravity of the white spots. The average circle equivalent diameter of the white spots was subtracted from the average distance between centers of gravity of the white spots to determine the average distance between two neighboring white spots. The same setting conditions as in Example 4 were used.

With respect to the dielectric strength of each sample, the dielectric breakdown strength (MV/m) was measured in the same way as in Example 4. Table 5 lists the results.

**[Table 5]**

| Sample No. | Dispersant (parts by mass) | Average distance of two neighboring white spots (µm) | Dielectric breakdown strength (MV/m) |
|---|---|---|---|
| 50 | 2.2 | 3 | 28 |
| 51 | 2.5 | 4 | 30 |
| 52 | 2.8 | 5 | 30 |
| 53 | 3.1 | 6 | 31 |
| 54 | 3.4 | 7 | 31 |

As listed in Table 5, each of samples 51 to 53 had a high dielectric breakdown strength value. The results indicated that in order to obtain high dielectric strength, the average distance between two neighboring white spots is preferably 4 µm or more.

### Reference Signs List

1 ceramic substrate (silicon nitride-based substrate)
2 bonding layer
2a exposed portion
2b mounting portion
2c void
3 circuit member
5 electronic component
10, 20, 30, 40 circuit board
S electronic device

## Claims

1. A circuit board (10), comprising:
a circuit member (3) located on one main surface of a ceramic substrate (1) with a bonding layer (2) therebetween,
wherein the bonding layer (2) comprises:
a mounting portion (2b) with the circuit member (3) mounted thereon; and
an exposed portion (2a) comprising voids (2c) on a surface thereof,
wherein an average value of dispersion of distances between centers of gravity of the voids (2c) is 3 or more and 55 or less, and
wherein the voids (2c) have an average circle equivalent diameter of 4 µm or more and 12 µm or less.

2. The circuit board (10) according to Claim 1, wherein pairs of the circuit member (3) and the bonding layer (2) are located on the one main surface of the ceramic substrate (1), and
the proportion of the total length of the exposed portions (2a) between two neighboring end faces of circuit members is 25% or more and 38% or less with respect to a length (L₀) between the two neighboring end faces.

3. The circuit board (10) according to Claim 1 or 2, wherein the mounting portion (2b) contains:
silver;
copper;
at least one element A selected from indium, zinc, and tin;
at least one element B selected from titanium, zirconium, hafnium, and niobium; and
at least one element C selected from molybdenum, osmium, rhenium, and tungsten,
wherein the mounting portion (2b) has a copper content of 35% by mass or more and 50% by mass or less, an element A content of 0.5% by mass or more and 22% by mass or less, an element B content of 1% by mass or more and 8% by mass or less, and an element C content of 9.5% by mass or more and 11.5% by mass or less, with the balance being silver, with respect to 100% by mass of the total contents of silver, copper, element A, element B, and element C.

4. An electronic device (5), comprising an electronic component (5) on the circuit member (3) of the circuit board (10) according to any one of Claims 1 to 3.

## Patentansprüche

1. Eine Leiterplatte (10), aufweisend:
ein Schaltungselement (3), das sich auf einer Hauptfläche eines Keramiksubstrats (1) mit einer Verbindungsschicht (2) dazwischen befindet,
wobei die Verbindungsschicht (2) aufweist:
einen Montageabschnitt (2b) mit dem darauf montierten Schaltungselement (3) und
einen freiliegenden Abschnitt (2a), der auf einer Oberfläche davon Hohlräume (2c) aufweist,
wobei ein durchschnittlicher Verteilungswert von Entfernungen zwischen Schwerpunkten der Hohlräume (2c) 3 oder mehr und 55 oder weniger beträgt, und
wobei die Hohlräume (2c) einen durchschnittlichen Kreisäquivalentdurchmesser von 4 µm oder mehr und 12 µm oder weniger haben.

2. Die Leiterplatte (10) gemäß Anspruch 1, wobei Paare des Schaltungselements (3) und der Verbindungsschicht (2) sich auf der einen Hauptfläche des Keramiksubstrats (1) befinden und
der Anteil der Gesamtlänge der freiliegenden Abschnitte (2a) zwischen zwei benachbarten Endflächen von Schaltungselementen bezogen auf eine Länge (L₀) zwischen den beiden benachbarten Endflächen 25% oder mehr und 38% oder weniger beträgt.

3. Die Leiterplatte (10) gemäß Anspruch 1 oder 2, wobei der Montageabschnitt (2b) enthält:
Silber,
Kupfer,
mindestens ein Element A, das aus Indium, Zink und Zinn ausgewählt ist,
mindestens ein Element B, das aus Titan, Zirkonium, Hafnium und Niob ausgewählt ist, und
mindestens ein Element C, das aus Molybdän, Osmium, Rhenium und Wolfram ausgewählt ist,
wobei der Montageabschnitt (2b) einen Kupfergehalt von 35 Masse-% oder mehr und 50 Masse-% oder weniger, einen Element-A-Gehalt von 0,5 Masse-% oder mehr und 22 Masse-% oder weniger, einen Element-B-Gehalt von 1 Masse-% oder mehr und 8 Masse-% oder weniger und einen Element-C-Gehalt von 9,5 Masse-% oder mehr und 11,5 Masse-% oder weniger hat, wobei der Rest Silber ist, bezogen auf 100 Masse-% der Gesamtgehalte an Silber, Kupfer, Element A, Element B und Element C.

4. Eine elektronische Vorrichtung (5), aufweisend eine elektronische Komponente (5) auf dem Schaltungselement (3) der Leiterplatte (10) gemäß irgendeinem der Ansprüche 1 bis 3.

## Revendications

1. Une carte de circuit (10), comprenant :
un élément de circuit (3) situé sur une surface principale d'un substrat céramique (1) avec une couche de liaison (2) entre ceux-ci,
dans laquelle la couche de liaison (2) comprend :
une partie de montage (2b) avec l'élément de circuit (3) monté sur celle-ci, et
une partie exposée (2a) comprenant des vides (2c) sur une surface de celle-ci,
dans laquelle une valeur moyenne de dispersion de distances entre des centres de gravité des vides (2c) est 3 ou plus et 55 ou moins, et
dans laquelle les vides (2c) ont un diamètre de cercle équivalent moyen de 4 µm ou plus et 12 µm ou moins.

2. La carte de circuit (10) selon la revendication 1, dans laquelle des paires de l'élément de circuit (3) et de la couche de liaison (2) sont situées sur ladite une surface principale du substrat céramique (1), et
la proportion de la longueur totale des parties exposées (2a) entre deux faces d'extrémité adjacentes d'éléments de circuit est 25 % ou plus et 38 % ou moins par rapport à une longueur (L₀) entre les deux faces d'extrémité adjacentes.

3. La carte de circuit (10) selon la revendication 1 ou 2, dans laquelle la partie de montage (2b) contient :
de l'argent,
du cuivre,
au moins un élément A choisi parmi l'indium, le zinc et l'étain,
au moins un élément B choisi parmi le titane, le zirconium, le hafnium et le niobium, et
au moins un élément C choisi parmi le molybdène, l'osmium, le rhénium et le tungstène,
dans laquelle la partie de montage (2b) a une teneur en cuivre de 35 % en masse ou plus et 50 % en masse ou moins, une teneur en un élément A de 0,5 % en masse ou plus et 22 % en masse ou moins, une teneur en un élément B de 1 % en masse ou plus et 8 % en masse ou moins, et une teneur en un élément C de 9,5 % en masse ou plus et 11,5 % en masse ou moins, le reste étant de l'argent, par rapport à 100 % en masse des teneurs totales d'argent, de cuivre, d'élément A, d'élément B et d'élément C.

4. Un dispositif électronique (5), comprenant un composant électronique (5) sur l'élément de circuit (3) de la carte de circuit (10) selon l'une quelconque des revendications 1 à 3.
